**Europäisches Patentamt**

**European Patent Office**

**Office européen des brevets**

(19)

(11) Numéro de publication : **0 492 029 B1**

## (12) FASCICULE DE BREVET EUROPEEN

(45) Date de publication du fascicule du brevet :
**11.11.92 Bulletin 92/46**

(51) Int. Cl.⁵ : **H03K 17/95**

(21) Numéro de dépôt : **90811020.8**

(22) Date de dépôt : **21.12.90**

(54) **Capteur de proximité inductif.**

(43) Date de publication de la demande :
**01.07.92 Bulletin 92/27**

(45) Mention de la délivrance du brevet :
**11.11.92 Bulletin 92/46**

(84) Etats contractants désignés :
**AT BE CH DE ES FR GB GR IT LI LU NL SE**

(56) Documents cités :
**EP-A- 0 237 171**
**WO-A-87/00933**
**GB-A- 2 040 054**

(73) Titulaire : **DETRA SA**
**35, Rue Scholl**
**CH-2504 Bienne (CH)**

(72) Inventeur : **Tu, Mai Xuan**
**Chiésaz 13**
**CH-1024 Ecublens (CH)**
Inventeur : **Schwab, Michel**
**Rue du Cornouiller 4**
**CH-2502 Bienne (CH)**

(74) Mandataire : **Rochat, Daniel Jean et al**
**Bovard SA Ingénieurs-Conseils ACP**
**Optingenstrasse 16**
**CH-3000 Bern 25 (CH)**

## Description

La présente invention a pour objet un capteur de proximité inductif utilisé pour détecter la proximité d'un objet métallique.

Des capteurs de proximité inductifs utilisant un circuit résonnant sont connus. Le principe de fonctionnement de ce type de capteur est le suivant: en l'absence d'un objet métallique à proximité du capteur, le circuit de mesure constitué par un oscillateur travaillant à la résonnance oscille à son amplitude maximale. La proximité d'un objet métallique provoque des pertes par courants de Foucault induits dans cet objet et par suite une atténuation de l'amplitude de la résonnance. La comparaison de cette amplitude avec une valeur de référence permet donc de détecter la présence des objets métalliques. Le grand désavantage de ce type de capteur réside dans la sensibilité aux pertes propres du circuit résonnant (pertes ohmiques dans la bobine du circuit, pertes par hystérésis dans le circuit magnétique de la bobine). En effet, ces pertes dépendent de la température, ce qui est une cause d'imprécision dans les résultats de la détection.

Un autre type de capteur de proximité inductif basé sur la mesure de la variation de l'inductance d'une bobine est décrit dans le document de brevet GB-2 040 054 A. Ce document propose une méthode de mesure de l'inductance par l'observation de la dérivée du courant dans la bobine dans la phase décroissante du courant. L'inconvénient majeur de ce type de capteur réside dans le fait qu'il est peu sensible à certains matériaux conducteurs non ferromagnétiques.

Le but de la présente invention est de remédier aux inconvénients précités en proposant un nouveau type de capteur de proximité inductif.

Dans ce but, l'objet de la présente invention est un capteur de proximité inductif comprenant une bobine, des moyens d'alimentation de la bobine, des moyens de mesure et de traitement de signaux capables de fournir une réponse en présence d'une pièce à détecter, lesdits moyens d'alimentation étant arrangés pour fournir à la bobine un courant périodique de période T, caractérisé en ce que le courant délivré par les moyens d'alimentation à la bobine circule dans cette dernière uniquement pendant une durée $T_1$ inférieure à T, et est pratiquement forcé à zéro pendant le reste $(T-T_1)$ de la dite période, un interrupteur $(SI_1)$ présentant une augmentation sensible de son impédance pendant la dite durée restante $(T-T_1)$, et en ce que les dits moyens de mesure et de traitement des signaux sont arrangés pour fournir une réponse par mesure de tension aux bornes de la bobine durant une période $(T_2)$ commençant après l'interruption du courant et inférieure ou égale à $(T-T_1)$ en présence de la pièce à détecter.

L'invention sera mieux comprise à la lecture de la description qui va suivre, en se référant au dessin annexé dans lequel:

- la figure 1 représente le schéma de principe du capteur selon l'invention,
- la figure 2 représente le diagramme temporel des tensions et courants relatifs au schéma de la figure 1
- la figure 3 représente un agrandissement de la tension induite aux bornes de la bobine de la figure 1,
- la figure 4 représente un exemple d'exécution du capteur selon l'invention,
- la figure 5 représente le diagramme temporel des tensions et courants relatifs au schéma de la figure 4,
- la figure 6 représente une variante d'exécution de l'exemple de la figure 4,
- la figure 7 représente une deuxième variante d'exécution de l'exemple de la figure 4,
- la figure 8 représente le diagramme temporel des signaux $S_4$, $S_5$, et $SI_1$ de l'exemple d'exécution selon la figure 7,
- la figure 9 représente un exemple d'exécution du moyen de filtrage (6) de la figure 7.

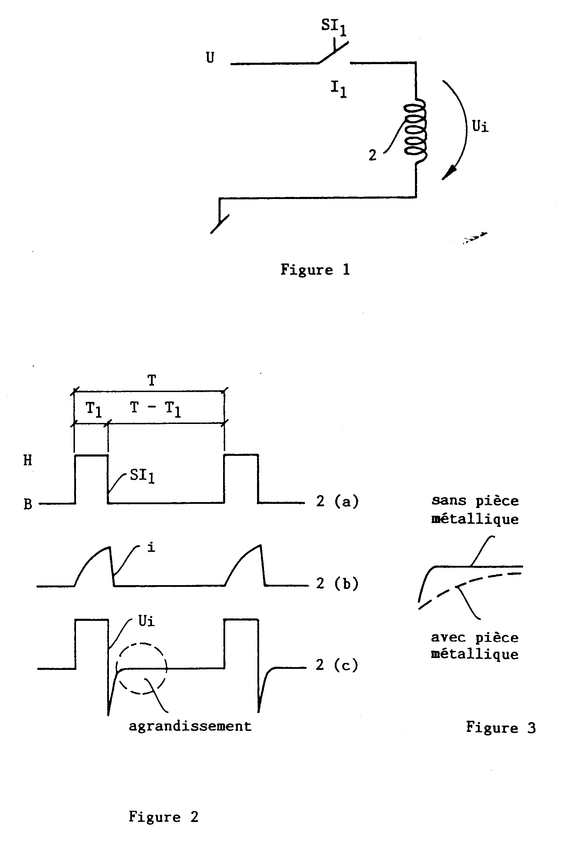

La figure 1 représente le schéma de principe du capteur selon l'invention. Une des bornes de la bobine 2 du capteur est reliée à la masse de l'alimentation, l'autre borne est reliée à une tension constante U à travers l'interrupteur $I_1$ commandé par le signal $SI_1$.

La figure 2 représente le diagramme temporel des tensions et courants relatifs au schéma de la figure 1. Le signal de commande $ST_1$ permet de fermer l'interrupteur $I_1$ lorsqu'il est au potentiel haut (H) et d'ouvrir $I_1$ lorsqu'il est au potentiel bas (B). L'interrupteur $I_1$ est ainsi commandé périodiquement avec la période T, il est fermé pendant la durée $T_1$ et ouvert pendant la durée $T-T_1$. Le courant i traversant la bobine 2 est de ce fait établi selon la figure 2b. La figure 2c représente la tension aux bornes de la bobine 2.

Un agrandissement de cette tension dans la période où le courant est nul dans la bobine permet de constater que l'amplitude de cette tension est très différente lorsqu'une pièce métallique se trouve à proximité du capteur; cet agrandissement est illustré à la figure 3.

Ce phénomène s'explique par le fait que la variation du courant dans la bobine pendant la durée $T_1$ provoque des courants induits dans la pièce métallique. Après l'extinction forcée du courant dans la bobine par l'ouverture de l'interrupteur $I_1$, les courants induits dans la pièce métallique continuent à circuler, induisant une tension aux bornes de la bobine. L'avantage de cette méthode de détection est la faible dépendance du signal mesuré en fonction de la température. En effet, la tension induite dans la bobine ne dépend pas de la résistance de cette dernière, mais seulement de l'intensité du courant induit dans la pièce métallique.

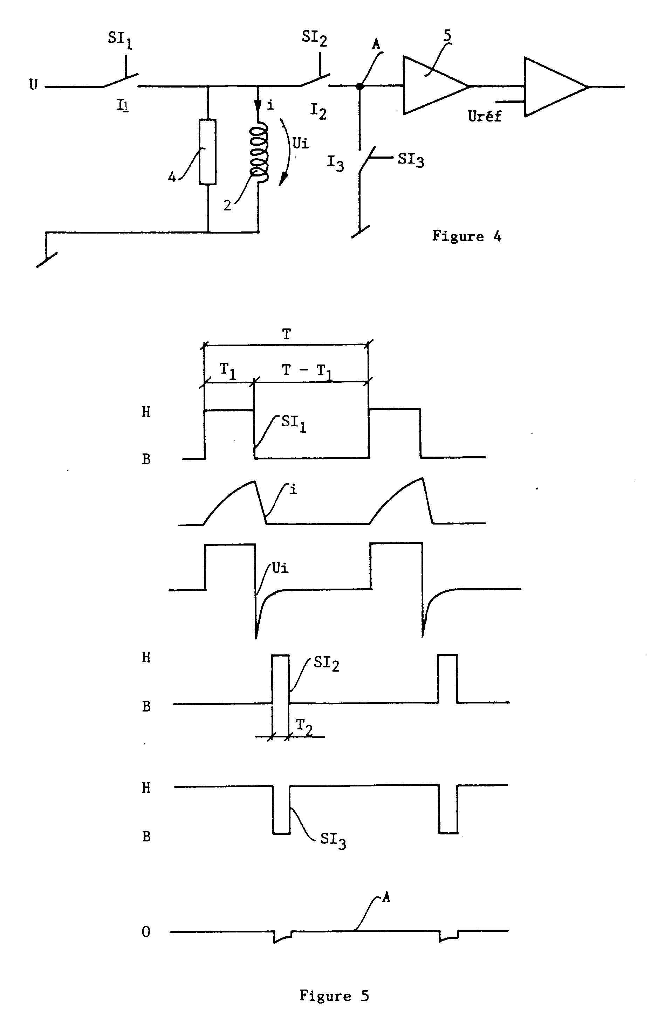

La figure 4 représente un exemple d'exécution du capteur selon l'invention.

Dans cet exemple d'exécution, la bobine (2) est mise en parallèle avec une résistance (4) dont la valeur est environ 50 fois celle de la bobine. Le rôle de cette résistance est d'amortir les oscillations dues à la commutation. Etant donné sa grande valeur, cette résistance n'influence pas la mesure de la tension induite. Les interrupteurs commandés $I_2$ et $I_3$ avec leurs signaux de commande $SI_2$ et $SI_3$ permettent la mesure de la tension induite seulement dans la durée $T_2$ dans laquelle le courant i dans la bobine est pratiquement nul. La tension induite ainsi traitée est envoyée sur l'amplificateur 5. La tension de sortie de l'amplificateur 5 est comparée à une valeur de référence permettant de détecter la proximité d'une pièce métallique.

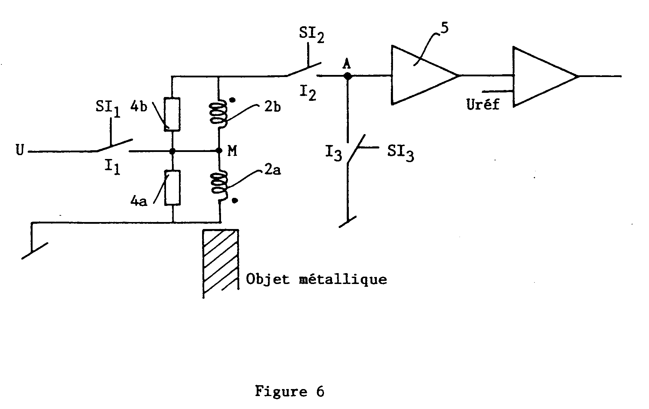

Dans la variante d'exécution représentée à la figure 6, la bobine du capteur possède une sortie intermédiaire M qui la partage en 2 portions 2a et 2b. Les résistances 4a et 4b jouent le même rôle d'amortisseur que la résistance 4 de la figure 4.

Les signaux de commande $SI_1$, $SI_2$, $SI_3$, sont identiques à ceux donnés à la figure 5.

Pendant la durée $T_1$, le courant circule dans la portion 2a de la bobine. L'ouverture de $I_1$ provoque des tensions induites dans les portions de bobine 2a et 2b. Vu le sens de bobinage, ces tensions induites sont en opposition de phase. La portion 2b, plus éloignée de la pièce métallique que 2a, fournit une tension induite plus faible et de ce fait, la tension induite résultante $V_i$ est différente de zéro.

Par contre, en présence d'un champ magnétique perturbateur, les tensions induites partielles dans les portions 2a et 2b sont sensiblement égales au signe près, fournissant ainsi une tension induite résultante $V_i$ pratiquement nulle. Cette variante d'exécution rend le capteur pour ainsi dire insensible aux perturbations extérieures.

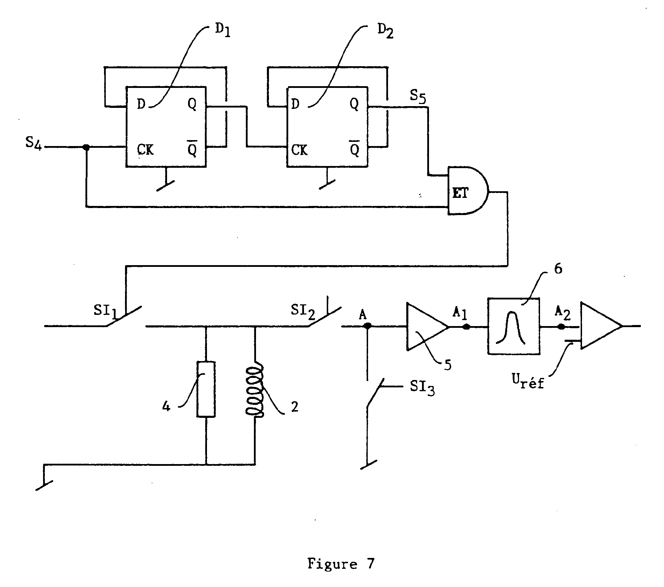

La figure 7 représente une variante d'exécution de l'exemple de la figure 4. Dans cette figure, le signal de commande de $SI_1$ s'obtient par la composition des signaux $S_4$ et $S_5$. Le signal $S_4$ de période $T_4$ est envoyé à l'entrée d'horloge "CK" d'une première bascule $D_1$, la sortie "Q" de la bascule $D_1$ est reliée à l'entrée d'horloge "CK" d'une deuxième bascule $D_2$; la sortie $S_5$ de la deuxième bascule $D_2$ possède donc une période T 4 fois plus grande que $T_4$. La composition des signaux $S_4$ et $S_5$ par une porte "ET" fournit le signal de commande $SI_1$ du capteur.

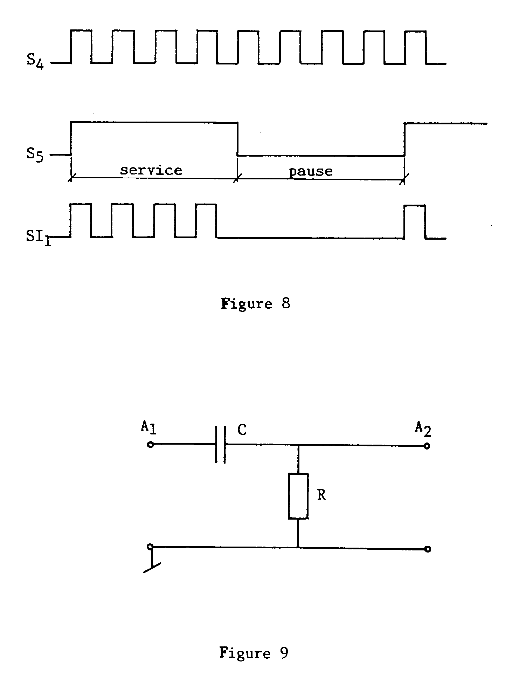

La figure 8 représente le diagramme temporel des signaux $S_4$, $S_5$ et $SI_1$. Le signal de commande $SI_1$ de cette variante d'exécution permet de créer une durée de pose "P" et une durée de service "S". La durée de pose créée a un double avantage : d'une part, elle permet de réduire la consommation moyenne du capteur, d'autre part, elle permet d'évaluer la composante continue (offset) introduite par l'amplificateur 5.

Pour supprimer la composante continue introduite par l'amplificateur 5, la sortie $A_1$ de cet amplificateur est reliée à un moyen de filtrage 6. Ce moyen de filtrage peut être réalisé simplement à l'aide d'un condensateur et d'une résistance, comme l'illustre la figure 9.

**Revendications**

1. Capteur de proximité inductif comprenant une bobine, des moyens d'alimentation de la bobine, des moyens de mesure et de traitement de signaux capables de fournir une réponse en présence d'une pièce à détecter, lesdits moyens d'alimentation étant arrangés pour fournir à la bobine un courant périodique de période T, caractérisé en ce que le courant délivré par les moyens d'alimentation à la bobine circule dans cette dernière uniquement pendant une durée $T_1$ inférieure à T, et est pratiquement forcé à zéro pendant le reste (T-T1) de la dite période, un interrupteur ($SI_1$) présentant une augmentation sensible de son impédance pendant la dite durée restante (T-$T_1$), et en ce que les dits moyens de mesure et de traitement des signaux sont arrangés pour fournir une réponse par mesure de tension aux bornes de la bobine durant une période $T_2$ commençant après l'interruption du courant et inférieure ou égale à (T-T1) en présence de la pièce à détecter.

2. Capteur de proximité inductif selon la revendication 1, caractérisé en ce que les moyens de mesure et de traitement des signaux sont arrangés pour mesurer uniquement la tension aux bornes de la bobine pendant une période $T_2$ de durée inférieure à (T-$T_1$).

3. Capteur de proximité inductif selon la revendication 1 ou selon la revendication 2, caractérisé en ce que la bobine est mise en parallèle avec une résistance (4) dont la valeur est sensiblement plus grande que celle de la bobine.

4. Capteur de proximité inductif selon une des revendications précédentes, caractérisé en ce que la bobine du capteur possède une sortie intermédiaire qui la partage en 2 portions, dont les sens de bobinage sont arrangés pour fournir une tension induite résultante égale à la somme de 2 tensions induites partielles en opposition de phase.

5. Capteur de proximité inductif selon les revendications 1 à 4, caractérisé en ce que le signal de commande $SI_1$ du dit courant périodique de période T s'obtient par la multiplication d'un signal périodique de période $T_4$ et d'un signal périodique de période T plus grande que $T_4$ et en ce que le signal de réponse du capteur après l'amplifica-

tion ($A_1$) est relié à un moyen de filtrage (6) permettant d'éliminer la composante continue introduite par l'amplificateur 5.

## Patentansprüche

1. Induktiver Näherungssensor mit einer Spule, Mitteln zum Speisen der Spule, Mitteln zum Messen und zum Verarbeiten von Signalen, die dazu bestimmt sind, beim Vorhandensein eines zu detektierenden Stückes zu reagieren, wobei die genannten Speisemittel zum Liefern eines periodischen Stromes mit der Periode T an die Spule vorgesehen sind, dadurch gekennzeichnet, dass der durch die Speisemittel an die Spule abgegebene Strom nur während einer Dauer $T_1$, die kleiner ist als T, in der Spule fliesst und während dem Rest ($T-T_1$) der genannten Periode praktisch auf null gehalten ist, dass ein Schalter ($SI_1$) während der genannten Restzeit ($T-T_1$) eine deutliche Impedanzerhöhung zeigt und dass die Mittel zum Messen und zum Verarbeiten von Signalen zum Liefern einer Antwort durch Spannungsmessung an den Anschlüssen der Spule während einer Zeitdauer $T_2$ bestimmt sind, wobei die Zeitdauer $T_2$ nach der Unterbrechung des Stomes beginnt und beim Vorhandensein des zu detektierenden Stückes kleiner oder gleich der Restzeit ($T-T_1$) ist.

2. Induktiver Näherungssensor nach Anspruch 1, dadurch gekennzeichnet, dass die Mittel zum Messen und zum Verarbeiten von Signalen nur zum Messen der Spannung an den Anschlüssen der Spule während einer Zeitdauer $T_2$, die kleiner als ($T-T_1$) ist, ausgeführt sind.

3. Induktiver Näherungssensor nach Anspruch 1 oder 2, dadurch gekennzeichnet, dass die Spule zu einem Widerstand (4) parallel geschaltet ist, dessen Widerstandswert bedeutend grösser ist als derjenige der Spule.

4. Induktiver Näherungssensor nach einem der Ansprüche 1 bis 3, dadurch gekennzeichnet, dass die Spule einen Zwischenanschluss aufweist, durch den die Spule des Sensors in zwei Teile aufgeteilt ist, wobei die Wicklungsrichtungen der beiden Teilspulen zum Liefern einer induzierten resultierenden Spannung, die gleich der Summe von zwei induzierten Teilspannungen mit gegenläufiger Phase ist, ausgeführt sind.

5. Induktiver Näherungssensor nach einem der Ansprüche 1 bis 4, dadurch gekennzeichnet, dass das Steuersignal $SI_1$ für den periodischen Strom mit der Periode T aus der Multiplikation eines periodischen Signales mit der Periode $T_4$ und einem

periodischen Signal mit der Periode T, welche grösser ist als $T_4$, erhalten wird und dass das Antwortsignal des Sensors nach einer Verstärkung ($A_1$) an ein Filtermittel (6) geschaltet ist, um die durch den Verstärker (5) eingeführte Gleichstromkomponente zu beseitigen.

## Claims

1. An inductive proximity sensor comprising a coil, means for feeding the coil, means for measuring and processing signals capable of yielding a response in the presence of an object to be detected, said feeding means being arranged for supplying the coil with a periodic current of a period T, characterized in that the current supplied by the feeding means to the coil flows in the latter solely for a duration $T_1$ less than T, and is practically forced to zero for the rest ($T-T_1$) of said period, a switch ($SI_1$) undergoing a substantial increase in its impedance during said remaining period ($T-T_1$), and in that said means for measuring and processing signals are arranged to yield a response by measuring the voltage at the terminals of the coil during a period $T_2$, commencing after the current has been interrupted, less than or equal to ($T-T_1$) in the presence of an object to be detected.

2. The inductive proximity sensor of claim 1, characterized in that the means for measuring and processing the signals are arranged to measure solely the voltage at the terminals of the coil during a period $T_2$ of a duration less than ($T-T_1$).

3. The inductive proximity sensor of claim 1 or 2, characterized in that the coil is connected in parallel with a resistor (4) having a value appreciably greater than that of the coil.

4. The inductive proximity sensor of one of the previous claims, characterized in that the coil of the sensor includes an intermediate output separating it into two parts, the directions of winding of said two parts being arranged to yield a resultant induced voltage equal to the sum of two partial induced voltages in phase opposition.

5. The inductive proximity sensor of claims 1 to 4, characterized in that the control signal $SI_1$ of said periodic current of period T is obtained by the multiplication of a periodic signal of period $T_4$ and a periodic signal of period T greater than $T_4$, and in that the response signal of the sensor after amplification ($A_1$) is connected to a filter means (6) allowing elimination of the DC component introduced by the amplifier 5.

Figure 1

2 (a)

2 (b)

2 (c)

agrandissement

Figure 2

sans pièce
métallique

avec pièce
métallique

Figure 3

Figure 4

Figure 5

6

Figure 6

Figure 7

S4

S5

service          pause

SI1

Figure 8

A1    C         A2

R

Figure 9